# EUROPÄISCHE PATENTSCHRIFT

(11) **EP 2 121 515 B1**
(45) Veröffentlichungstag und Bekanntmachung des Hinweises auf die Patenterteilung: **07.09.2011**
(21) Anmeldenummer: 08734374.5
(22) Anmeldetag: 13.03.2008
(51) Int. Cl.: B81C 1/00

(54) **VERFAHREN ZUR HERSTELLUNG EINES MIKROMECHANISCHEN BAUELEMENTS MIT EINER PARTIELLEN SCHUTZSCHICHT**
METHOD FOR PRODUCING A MICROMECHANICAL COMPONENT COMPRISING A PARTIAL PROTECTIVE LAYER
PROCÉDÉ DE PRODUCTION D'UN COMPOSANT MICROMÉCANIQUE DOTÉ D'UNE COUCHE DE PROTECTION PARTIELLE

(30) Priorität: 20.03.2007 DE 102007013329
(43) Veröffentlichungstag der Anmeldung: 25.11.2009
(73) Patentinhaber: Fraunhofer-Gesellschaft zur Förderung der angewandten Forschung e.V., 80686 München (DE)
(72) Erfinder: MERZ, Peter, 25557 Beldorf (DE); REIMER, Klaus, 25524 Itzehoe (DE); SENGER, Frank, 25569 Kremperheide (DE)
(74) Vertreter: Gagel, Roland
(86) Internationale Anmeldenummer: PCT/DE2008/000434
(87) Internationale Veröffentlichungsnummer: WO 2008/113325

(56) Entgegenhaltungen:
- WO-A-01/35433
- DE-A1- 19 820 816

## Beschreibung

### Technisches Anwendungsgebiet

Die vorliegende Erfindung betrifft ein Verfahren zur Herstellung eines mikromechanischen Bauelements mit mindestens einer freitragenden Struktur, bei dem eine Leiterbahnebene und eine Opferschicht so auf ein Substrat aufgebracht werden, dass die Leiterbahnebene zwischen Substrat und Opferschicht oder innerhalb der Opferschicht liegt, auf die Opferschicht eine die freitragende Struktur bildende Schicht oder Schichtfolge abgeschieden wird und die Opferschicht zur Fertigstellung der freitragenden Struktur durch einen Ätzprozess teilweise entfernt wird.

Mikromechanische Bauelemente mit freitragenden Strukturen kommen in vielen technischen Bereichen zum Einsatz. So können mikromechanische Bauelemente beispielsweise als Beschleunigungssensoren, als Drucksensoren, als HF-Schalter oder als bewegliche Mikrospiegel ausgeführt werden.

### Stand der Technik

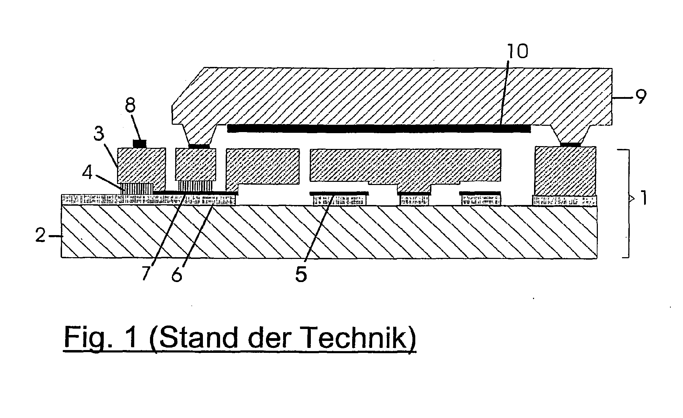

Fig. 1 zeigt einen typischen Aufbau eines mikrosystemtechnisch hergestellten, resonanten Inertialsensors, wie er beispielsweise aus P. Merz et al., "PSM-X2: Polysilicon surface micromachining process platform for vacuum-packed sensors", Konferenzband Mikrosystemtechnik-Kongress 2005, Freiburg, Seiten 467 bis 470 bekannt ist. Der unten liegende, Oberflächen-mikromechanische Sensor 1 enthält die aktive Sensorstruktur. Er umfasst ein Trägersubstrat 2, auf dem eine Schichtfolge mit der aktiven Schicht 3, auch als aktive MEMS-Schicht (MEMS: Micro Electro Mechanical Sensor) bezeichnet, aufgebracht ist. Durch einen spezifischen Ätzschritt, bei dem eine Opferschicht 4 unterhalb der aktiven MEMS-Schicht 3 teilweise entfernt wird, können freitragende Strukturen hergestellt werden. Für die kapazitive Detektion von Bewegungen aus der Ebene sind in einem Abstand von etwa 1,5 µm Gegenelektroden 5 implementiert. In der Fig. 1 sind auch eine Isolationsschicht 6 auf dem Trägersubstrat 2 sowie in einem Bereich eine Verbindungsschicht 7 für die elektrische Verbindung der freitragenden Struktur mit dem Außenbereich erkennbar. Die Kontaktierung von außen erfolgt in diesem Beispiel über Aluminium-Anschlussflächen 8. Die Bewegungsrichtung mikromechanischer Systeme ist somit nicht nur auf Bewegungen in der Ebene (in-plane) beschränkt, sondern es können auch so genannte out-of-plane Bewegungen angeregt und detektiert werden. Die freitragende Struktur ist über einen oberen Deckel-Chip 9 hermetisch gegen die Außenwelt abgeschlossen. In diesem Deckel-Chip 9 ist über der freitragenden Struktur in diesem Beispiel eine 60 µm tiefe Kavität eingebracht, in der eine Schicht aus Gettermaterial 10 zur Absorption und chemischen Bindung von Gasmolekülen abgeschieden ist. Die feste Verbindung zwischen Sensor 1 und Deckel-Chip 9 erfolgt auf Waferebene durch das so genannte Wafer-Level-Packaging, in diesem Beispiel über ein Gold-Silizium-Eutektikum. Der Bondrahmen aus Gold-Silizium sorgt für eine hermetische Kapselung, so dass der beim eutektischen Verbindungsprozess eingestellte Druck erhalten bleibt. Durch die Getterschicht 10 in der Kavität wird sichergestellt, dass ein minimaler Kavitäts-Innendruck von bis zu 1 x 10⁻¹ Pa (1 x 10⁻⁶ bar) eingestellt und über die gesamte Lebensdauer des Bauelements erhalten werden kann.

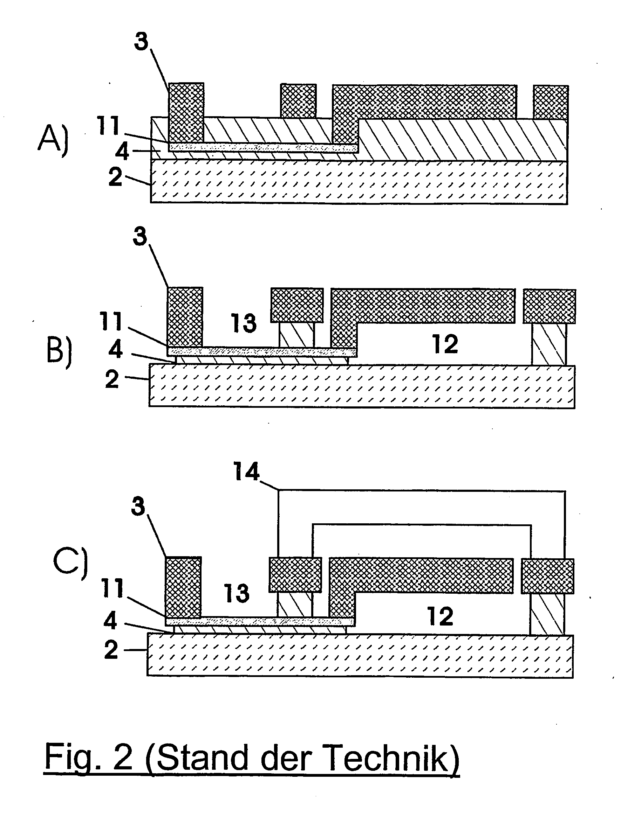

Für die Fertigung von hochpräzisen mikromechanischen Bauelementen werden mit verschiedensten Standardverfahren der Mikrotechnologie funktionelle und strukturelle Schichten aufgebracht und strukturiert. Für die Herstellung von Oberflächen-mikromechanischen Systemen wird beispielsweise der in Fig. 2 dargestellte prinzipielle Schichtaufbau verwendet. Auf einem Wafersubstrat 2, das typischerweise aus Silizium, Glas oder GaAs besteht, wird eine Opferschicht 4, beispielsweise aus SiO₂, abgeschieden und gegebenenfalls strukturiert. Diese Opferschicht kann auch zur elektrischen Isolierung (Passivierung) von elektrischen Leiterbahnebenen und zur Reduzierung von elektrischen Feldern bzw. zur Verringerung von Streukapazitäten genutzt werden. Als Material hierfür sind Siliziumoxid, Siliziumnitrid oder Aluminiumnitrid verbreitet. Andere Materialien mit geeigneten Eigenschaften können auch verwendet werden.

In die Opferschicht 4 wird eine Leiterbahnebene 11 eingebettet, welche verschiedene Gebiete des mikromechanischen Bauteils elektrisch miteinander verbindet. Die Leiterbahnebene 11 kann z.B. aus elektrisch leitfähigem, dotiertem LPCVD-Silizium mit einer Dicke von 0,1 bis 2 µm ausgeführt und mittels reaktivem Ionenätzen (RIE) lateral strukturiert werden. Um die Leitfähigkeit zu erhöhen, kann die Siliziumschicht mit Fremdatomen wie Phosphor, Bor oder Arsen dotiert werden. Die Dotierung kann beispielsweise durch Diffusion aus einer dotierten Glasschicht (z.B. POCL₃-Prozess) oder durch Ionenimplantation erfolgen. Für die Einbettung der Leiterbahnebene 11 in die Opferschicht 4 kann beispielsweise zuerst eine Teilschicht des Opferoxids abgeschieden werden. Anschließend wird die Leiterbahnebene 11 aufgebracht und strukturiert. Schließlich wird der noch fehlende Teil der Opferschicht ganzflächig abgeschieden. Zur Kontaktierung der Leiterbahnebene 11 wird ein Bereich der Opferschicht 4 von oben geöffnet, so dass die Leiterbahnebene 11 an den gewünschten Stellen freigelegt wird. Eine selektive Ätzung von SiO₂ zu Si kann z.B. mit einer BOE-Mischung (Buffered Oxide Etch: NH₃F + HF + H₂O) oder mit HF erfolgen. Denkbar sind auch RIE-Plasmaprozesse.

Auf die Opferschicht 4 wird nun ganzflächig die aktive MEMS-Schicht 3 abgeschieden. Beispielsweise kann hier epitaktisch aufgewachsenes Polysilizium (Epi-Polysilizium) verwendet werden, welches sich durch größe Schichtdicken mit geringer Schichtspannung und geringem Spannungsgradienten auszeichnet. Durch die Öffnungen im Opferoxid wird ein Materialkontakt zur Leiterbahnebene 11 hergestellt, wie dies aus der Darstellung der Fig. 2a ersichtlich ist. Die aktive MEMS-Schicht 3 wird wiederum strukturiert, so dass Teilbereiche des Opferoxids freigelegt werden.

Anschließend erfolgt die Entfernung des Opferoxids in den von oben zugänglichen Bereichen (vgl. Fig. 2b) zur Bildung freigeätzter Bereiche 12. Dadurch werden nun Teile der aktiven MEMS-Schicht 3 freitragend bzw. beweglich. Diese freitragenden Strukturen sind an definierten Verankerungspunkten aufgehängt. Die beweglichen Bereiche lassen sich durch äußere Krafteinwirkung wie beispielsweise elektrische Felder oder Beschleunigung in Bewegung versetzen. Mit dieser Opferschicht-Technik lässt sich eine Reihe von elektromechanischen und optischen Mikrosystemen realisieren.

Die Bauteile, insbesondere deren bewegliche bzw. freitragende Strukturen, müssen vor Umwelteinflüssen wie mechanischer oder chemischer Zerstörung, Verschmutzung oder auch Feuchte geschützt werden. Dazu kann der mikromechanisch aktive Bereich mit einer Kappe bzw. einem Deckel überdeckt werden. Zudem kann mit einer hermetischen Verkappung eine definierte Betriebsatmosphäre eingeschlossen werden. Das Aufbringen einer Schutzkappe kann auf Wafer-Ebene oder auch auf Chip-Ebene erfolgen. Die Verkappung auf Wafer-Ebene bietet den Vorteil, dass die sensiblen Bereiche bei nachfolgenden Prozessen geschützt sind. Insbesondere das Auftrennen des Wafers in einzelne Bauelemente durch Sägen kann, bedingt durch die hohe Spindeldrehzahl des Sägeblattes, zu einer starken mechanischen Schädigung von mikromechanischen Strukturen führen. Zudem werden der Sägeprozess durch Wasser gekühlt und anfallender Sägestaub mit dem Wasser entfernt. Durch den Wasserstrahl können Schädigungen an den Strukturen entstehen und sich zum anderen Restfeuchte auf Oberflächen und insbesondere in Einbuchtungen ansammeln.

Fig. 2c zeigt eine typische Vorgehensweise zum Schutz der freitragenden Strukturen, bei der eine Schutzkappe 14 über der freitragenden Struktur aufgebracht ist. Die freigeätzten Bereiche 13 mit offenen Leiterbahnstrukturen stellen ebenfalls kritische Bereiche des Bauelementes dar. Nach dem Entfernen des Opferoxides sind dort die Leiterbahnen der Leiterbahnebene 11 freigelegt. Zudem werden sie in der Regel durch das Opferschicht-Ätzen auch seitlich unterätzt, so dass die mechanische Stabilität reduziert ist. Liegen diese sensiblen Bereiche außerhalb der durch die Kappe 14 geschützten Flächen, so sind die Leiterbahnen anfällig gegenüber mechanischer Einwirkung, Partikel oder Feuchte. Durch mechanische Einwirkung können die Leiterbahnen beschädigt werden, so dass sie ihre Funktionalität verlieren. Partikel und Oberflächenfeuchte können Kurzschlüsse oder Nebenschlüsse zwischen zwei Leiterbahnen verursachen. Abbrüche in der Leiterbahnebene führen zu Kurzschlüssen zu den darunter liegenden Schichten (hier Substrat 2). Daher ist es wünschenswert, derartige elektrische Schichten durch nicht leitende, mechanisch stabile Schichten zu schützen.

Zum Schutz sensibler Sensorstrukturen wird in der US 6401544 B2 ein allgemeines Verfahren vorgeschlagen, bei dem über der gesamten zu schützenden Struktur eine Schutzschicht abgeschieden wird.

Die US 6187607 B1 zeigt ein Verfahren zur Herstellung eines mikromechanischen Bauelements mit freitragenden Strukturen, bei dem über zu schützenden Bereichen lokal eine Schutzschicht auf die Opferschicht aufgebracht wird, um dort ein unerwünschtes Unterätzen zu verhindern. Dabei wird eine Schichtfolge aus LPCVD-Silizium mit darüber liegendem Siliziumdioxid vorgeschlagen.

Die Dokumente WO 01/35433 A2 und DE 198 20 816 A1 offenbaren weitere Verfahren in denen über die zu schützende Strukturen eine Schutzschicht aufgebracht wird.

Die Aufgabe der vorliegenden Erfindung besteht darin, ein Verfahren zur Herstellung eines mikromechanischen Bauelements mit mindestens einer freitragenden Struktur anzugeben, bei dem Leiterbahnstrukturen während der Herstellung des Bauelementes in einfacher Weise geschützt werden können. Das Verfahren soll kompatibel mit IC-Prozesstechnologien und Hochtemperaturverfahren sein.

### Darstellung der Erfindung

Die Aufgabe wird mit dem Verfahren gemäß Patentanspruch 1 gelöst. Vorteilhafte Ausgestaltungen des Verfahrens sind Gegenstand der Unteransprüche oder lassen sich der nachfolgenden Beschreibung sowie dem Ausführungsbeispiel entnehmen.

Bei dem vorgeschlagenen Verfahren werden in bekannter Weise zumindest eine Leiterbahnebene und eine Opferschicht so auf ein Substrat aufgebracht, dass die Leiterbahnebene zwischen Substrat und Opferschicht oder innerhalb der Opferschicht liegt. Die Opferschicht kann hierbei bei Bedarf zusätzlich strukturiert werden, um eine bestimmte geometrische Form von Bereichen der freitragenden Struktur, beispielsweise Verankerungspunkte dieser Struktur, festzulegen. Anschließend wird eine die freitragende Struktur bildende Schicht oder Schichtfolge, die so genannte aktive MEMS-Schicht, über der Opferschicht abgeschieden. Die Opferschicht wird dann zur Fertigstellung der freitragenden Struktur durch einen Ätzprozess teilweise entfernt. Das vorgeschlagene Verfahren zeichnet sich dadurch aus, dass beim Aufbringen der Opferschicht oberhalb eines zu schützenden Bereichs der Leiterbahnebene eine elektrisch leitfähige Schutzschicht in die Opferschicht eingebettet wird, die als Ätzstopp-Schicht beim Ätzprozess für die Entfernung der Opferschicht dient. Die Schutzschicht wird dabei in einem Abstand zur Leiterbahnebene eingebettet, so dass zwischen der Schutzschicht und der Leiterbahnebene noch eine dünne Schicht aus dem Opferschichtmaterial vorhanden ist.

Auch die die freitragende Struktur bildende Schicht oder Schichtfolge kann selbstverständlich nach der Abscheidung über der Opferschicht strukturiert werden, um die gewünschte geometrische Form bzw. Struktur zu erhalten. Die Schutzschicht wird nach der Fertigstellung der freitragenden Struktur durch einen selektiven Ätzprozess wieder entfernt, bei dem der zwischen der Schutzschicht und der Leiterbahnebene verbliebene Teil der Opferschicht nicht beseitigt wird.

Die Leiterbahnebene wird mit dem vorgeschlagenen Verfahren in den zu schützenden Bereichen durch eine dünne Opferschicht geschützt, die eine nicht leitende Passivierung bildet. Diese verbliebene dünne Opferschicht bewirkt sowohl einen mechanischen Schutz der Leiterbahnen als auch einen Schutz vor Feuchte und Korrosion. Sie vermindert aufgrund ihrer elektrisch nicht leitenden Eigenschaft auch die Gefahr von Kurzschlüssen oder Nebenschlüssen in der Leiterbahnebene. Die Herstellung dieser nicht leitenden Passivierung erfordert lediglich die Einbettung und Strukturierung der zusätzlichen Schutzschicht beim Herstellungsprozess sowie den anschließenden Ätzprozess zur Entfernung der Schutzschicht. Das Verfahren ist damit kompatibel mit den bekannten IC-Prozesstechnologien und Hochtemperaturverfahren. Es sind keine neuen Materialsysteme und Prozesse erforderlich. Besonders vorteilhaft lässt sich die Schutzschicht in bestehende Oberflächen-mikromechanische Prozesse einbinden, bei denen eine Schichtkombination aus einer aktiven MEMS-Schicht aus Silizium und einer Opferschicht aus Siliziumoxid zum Einsatz kommen. Die elektrisch leitfähige Ausgestaltung der Schutzschicht hat den besonderen Vorteil, dass die vollständige Entfernung dieser Schutzschicht durch eine Leitfähigkeitsmessung an der Oberfläche der verbliebenen Opferschicht in einfacher Weise überprüft werden kann. Dies trägt zur Qualitätssicherung bei der Herstellung der mikromechanischen Bauteile bei.

In der bevorzugten Ausgestaltung des Verfahrens wird der Bereich mit den freitragenden Strukturen mit einer Schutzkappe hermetisch abgedeckt. Die Entfernung der Schutzschicht durch einen Ätzprozess wird dann erst nach dem Aufbringen der Schutzkappe durchgeführt. Damit kann die Schutzschicht aus demselben Material wie die aktive MEMS-Schicht bestehen, beispielsweise aus Silizium. Der aktive Bereich mit den freitragenden Strukturen bleibt durch die Schutzkappe während der Entfernung der Schutzschicht geschützt.

Das Einbetten der zusätzlichen Schutzschicht in die Opferschicht erfolgt vorzugsweise, indem die Opferschicht in mehreren Stufen aufgebracht wird. Die Aufbringung bzw. das Abscheiden der Opferschicht wird dabei unterbrochen, nachdem die gewünschte Schichtdicke der Opferschicht für die spätere Passivierung über der Leiterbahnebene aufgebracht ist. Dann wird die Schutzschicht auf diese teilweise abgeschiedene Opferschicht aufgebracht und so strukturiert, dass sie über den zu schützenden Bereichen verbleibt und in Bereichen fehlt, in denen die Opferschicht später vollständig entfernt werden soll. Nach dieser Strukturierung wird das Abscheiden bzw. die Aufbringung der Opferschicht bis zu der für die Erzeugung der freitragenden Struktur erforderlichen Dicke fortgesetzt.

Das vorgeschlagene Verfahren lässt sich für die Herstellung von mikromechanischen Bauelementen mit freitragenden Strukturen einsetzen, die in vielen technischen Bereichen einsetzbar sind. Beispiele für aktuatorische und sensorische Anwendungsbereiche für diese Technologie sind Beschleunigungssensoren, Drehratensensoren, Drehbeschleunigungssensoren, Drucksensoren, Magnetfeldsensoren, Mikrofone, HF-Schalter, variable Kapazitäten, Mikrospiegel oder Mikrospiegel-Arrays. Dies ist selbstverständlich keine abschließende Aufzählung.

### Kurze Beschreibung der Zeichnungen

Das vorgeschlagene Verfahren wird nachfolgend anhand eines Ausführungsbeispiels in Verbindung mit den Zeichnungen nochmals näher erläutert. Hierbei zeigen:
- Fig. 1: ein Beispiel für den Aufbau eines mikro- mechanischen Inertialsensors des Standes der Technik;
- Fig. 2: ein Beispiel für den bekannten Verfahrens- ablauf zur Herstellung eines mikromechanischen Bauelements mit einer freitragenden Struktur;
- Fig. 3: schematisch ein Beispiel für den Verfahrens- ablauf bei der Durchführung des erfindungs- gemäßen Verfahrens; und
- Fig. 4: ein weiteres Beispiel für die Herstellung eines mikromechanischen Bauelements gemäß dem erfindungsgemäßen Verfahren.

### Wege zur Ausführung der Erfindung

Im folgenden Beispiel wird das vorgeschlagene Verfahren für die Herstellung eines mikromechanischen Bauelements mit einer freitragenden Struktur erläutert, bei dem die freitragende Struktur durch eine zusätzliche Schutzkappe abgedeckt wird. Viele der Verfahrensschritte für die Herstellung dieses mikromechanischen Bauteils stimmen mit den Verfahrensschritten überein, wie sie bereits in der Beschreibungseinleitung in Verbindung mit den Fig. 2A-C erläutert wurden. Dies betrifft auch die dort angeführten Möglichkeiten der Materialwahl für die einzelnen Schichten und Ätzprozesse. Im Folgenden wird daher lediglich auf die Unterschiede eingegangen, die das vorgeschlagene Verfahren gegenüber dem Verfahren der Fig. 2A-C aufweist.

Bei dem vorgeschlagenen Verfahren wird in den später nicht durch eine Schutzkappe geschützten sensiblen Bereichen, in denen Leiterbahnen freiliegen würden, eine dünne elektrisch leitfähige Schutzschicht 15 in die Opferschicht 4 eingebettet.

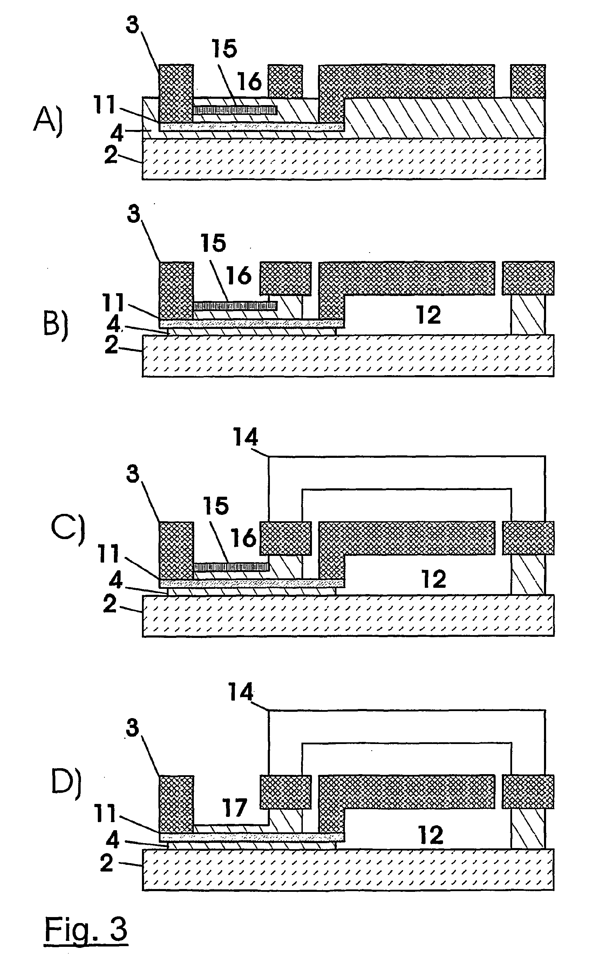

Dies ist in der Fig. 3a ersichtlich. Für die Einbettung dieser Schutzschicht 15 wird im vorliegenden Beispiel die Opferschicht 4 in mehreren Stufen abgeschieden. Zunächst erfolgt die Abscheidung dieser Opferschicht bis zu einer ersten Schichtdicke, die den Abstand der Leiterbahnebene 11 zum Substrat 2 festlegt. Nach dieser ersten Abscheidung der Opferschicht, im vorliegenden Beispiel aus SiO₂, bis zu der ersten Dicke erfolgt die Abscheidung und Strukturierung der Leiterbahnebene 11. Anschließend wird die Abscheidung der Opferschicht 4 fortgesetzt, bis die gewünschte Schichtdicke über der Leiterbahnebene 11 für die spätere Passivierung dieser Leiterbahnebene 11 durch die Opferschicht 4 erreicht ist. Im Anschluss daran erfolgt die Abscheidung der Schutzschicht 15, im vorliegenden Beispiel aus elektrisch leitfähigem, dotiertem LPCVD-Silizium. Diese Schutzschicht 15 wird so strukturiert, dass sie nur im Bereich der später zu schützenden, durch die Ätzung der Opferschicht 4 freigelegten Bereiche 16 vorhanden ist und die Herstellung der freitragenden Strukturen in den verbleibenden Bereichen nicht behindert. Nach der Abscheidung und Strukturierung dieser Schutzschicht 15 wird die Abscheidung der Opferschicht 4 bis zu der Gesamtdicke fortgesetzt, die für die Herstellung der freitragenden Strukturen erforderlich ist.

Im nächsten Schritt wird, wie in Verbindung mit Fig. 2 bereits beschrieben, die Opferschicht 4 durch einen Ätzprozess teilweise entfernt, so dass die aktive MEMS-Schicht 3 durch die dabei entstandenen Kavitäten 12 frei beweglich wird. In dem durch die Schutzschicht 15 zu schützenden Bereich stoppt die Ätzung jedoch an der Schutzschicht 15, die als Ätzstoppschicht für diesen Ätzprozess wirkt (Fig. 3b). Die darunter liegenden Leiterbahnen werden somit nicht freigelegt und auch nicht unterätzt.

Anschließend wird der aktive Sensorbereich mit den freitragenden Strukturen mit einer Schutzkappe 14 versehen. Dies kann z.B. durch verschiedenste Wafer-Level-Packaging-Verfahren wie Glasfrit-Bonden, eutektisches Bonden oder anodisches Bonden erfolgen (vgl. Fig. 3c).

Schließlich wird die Schutzschicht 15 in einem nachfolgenden Prozessschritt entfernt. Dabei ist der aktive Sensorbereich durch die Kappe 14 geschützt. Die Ätzung der Schutzschicht 15 erfolgt dabei selektiv zur darunter verbliebenen Opferschicht 17. Für dotiertes Silizium als Material für die Schutzschicht 15 ergeben sich damit unter anderem folgende Möglichkeiten:
- nasschemisches Ätzen mit TMAH, KOH oder Ethylende-Diaminepyrocatechol;
- Plasma RIE-Ätzen mittels SF₆, CF₄, CHF₃ usw.;
- Trockenätzen mittels XeF₂.

Durch diese Ätzung wird der unter der Schutzschicht 15 liegende Teil der Opferschicht 4 nicht oder nur zu Teilen entfernt, so dass die Passivierung der Leiterbahnebene 11 durch diese verbliebene Opferschicht 17 erhalten bleibt (Fig. 3d).

Durch das lokale Einbetten der Schutzschicht 15 in die Opferschicht 4 werden partiell bestimmte zu schützende Sensorbereiche abgedeckt. Die Schutzschicht 15 schützt bei der zur lokalen Beseitigung der Opferschicht erforderlichen Ätzung die unter der Schutzschicht liegende sensible Sensorschicht vor chemischen oder physikalischen Angriffen. Die Schutzschicht 15 wird in einem nachfolgenden Prozess wieder entfernt, wodurch die ursprüngliche Funktionalität des sensiblen Sensorbereichs wieder hergestellt wird. Darunter liegende elektrische Leiterbahnen bleiben durch die verbliebene dünne Opferschicht 17 abgedeckt und sind somit passiviert. Die Dicke dieser verbliebenen Opferschicht 17 wird vorzugsweise im Bereich von ≥ 100 nm bis einigen µm gewählt.

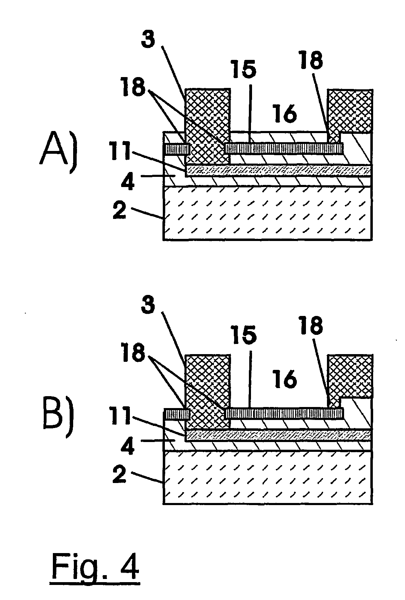

Figur 4 zeigt ein weiteres Beispiel für die Herstellung eines mikromechanischen Bauelements gemäß dem vorgeschlagenen Verfahren. Gleiche Bezugszeichen entsprechen hierbei den gleichen Elementen wie in den vorangehenden Figuren. In diesem Beispiel wird die Schutzschicht 15 derart geometrisch ausgeführt und die Opferschicht 4 derart strukturiert, dass die angrenzende aktive MEMS-Schicht 3 anschließend auf dem Rand der Schutzschicht aufliegt (Fig. 4a). Hierdurch entsteht eine zusätzliche Kontaktierungsfläche 18 der aktiven MEMS-Schicht 3 auf der Schutzschicht 15, durch die lokale Unterätzungen beim Entfernen der Opferschicht 4 vermieden werden (Fig. 4b). Dadurch sind diese Kantenbereiche mechanisch stabiler und durch nachfolgende Prozesse (Sägen oder Reinigen) induzierte Kantenabbrüche an kritischen Bereichen (Pads) werden verhindert. Somit werden Partikel minimiert, die zu Kurzschlüssen führen können.

### Bezugszeichenliste

- 1: Sensor
- 2: Trägersubstrat
- 3: Aktive MEMS-Schicht
- 4: Opferschicht
- 5: Gegenelektroden
- 6: Isolationsschicht
- 7: Verbindungsschicht
- 8: Aluminium-Anschlussflächen
- 9: Deckel-Chip
- 10: Schicht aus Gettermaterial
- 11: Leiterbahnebene
- 12: Freigeätzter Bereich
- 13: Freigeätzter Bereich mit offenen Leiterbahnstrukturen
- 14: Schutzkappe
- 15: Schutzschicht
- 16: Freigeätzter Bereich mit abgedeckten Leiterbahnstrukturen
- 17: verbliebene Opferschicht zur Passivierung der Leiterbahnstrukturen
- 18: zusätzliche Kontaktierungsfläche

## Patentansprüche

1. Verfahren zur Herstellung eines mikromechanischen Bauelements mit mindestens einer freitragenden Struktur, bei dem eine Leiterbahnebene (11) und eine Opferschicht (4) so auf ein Substrat (2) aufgebracht werden, dass die Leiterbahnebene (11) zwischen Substrat (2) und Opferschicht (4) oder innerhalb der Opferschicht (4) liegt, auf die Opferschicht (4) eine die freitragende Struktur bildende Schicht (3) oder Schichtfolge abgeschieden wird und die Opferschicht (4) zur Fertigstellung der freitragenden Struktur durch einen Ätzprozess teilweise entfernt wird, wobei bei dem Aufbringen der Opferschicht (4) oberhalb eines zu schützenden Bereichs der Leiterbahnebene (11) eine elektrisch leitfähige Schutzschicht (15) in einem Abstand zur Leiterbahnebene (11) in die Opferschicht (4) eingebettet wird, die als Ätzstoppschicht beim Ätzprozess für die Entfernung der Opferschicht (4) dient, **dadurch gekennzeichnet, dass** die Schutzschicht (15) nach Fertigstellung der freitragenden Struktur durch einen Ätzprozess entfernt wird, der selektiv zu einem unterhalb der Schutzschicht (15) verbliebenen Teil (17) der Opferschicht wirkt, die auf der Leiterbahnebene (11) verbleibt.

2. Verfahren nach Anspruch 1,
**dadurch gekennzeichnet,**
**dass** nach der Fertigstellung der freitragenden Struktur zunächst eine Schutzabdeckung (14) über der freitragenden Struktur aufgebracht wird, die die freitragende Struktur gegenüber äußeren Einflüssen hermetisch abschließt, und anschließend die Schutzschicht (15) durch den Ätzprozess entfernt wird.

3. Verfahren nach Anspruch 1 oder 2,
**dadurch gekennzeichnet,**
**dass** zunächst die Leiterbahnebene (11) auf das Substrat (2) aufgebracht und strukturiert und anschließend die Opferschicht (4) aufgebracht wird, wobei das Aufbringen der Opferschicht (4) bei Erreichen einer ersten Schichtdicke unterbrochen wird, die Schutzschicht (15) abgeschieden und für einen lokalen Verbleib über dem zu schützenden Bereich strukturiert wird, und anschließend das Aufbringen der Opferschicht (4) fortgesetzt wird.

4. Verfahren nach Anspruch 1 oder 2,
**dadurch gekennzeichnet,**
**dass** das Aufbringen der Opferschicht (4) bei Erreichen einer ersten Schichtdicke unterbrochen wird, die Leiterbahnebene (11) aufgebracht und strukturiert wird, das Aufbringen der Opferschicht (4) fortgesetzt und bei Erreichen einer zweiten Schichtdicke nochmals unterbrochen wird, die Schutzschicht (15) abgeschieden und für den lokalen Verbleib über dem zu schützenden Bereich strukturiert wird, und anschließend das Aufbringen der Opferschicht (4) wiederum fortgesetzt wird.

5. Verfahren nach einem der Ansprüche 1 bis 4,
**dadurch gekennzeichnet,**
**dass** die Opferschicht (4) vor dem Abscheiden der die freitragende Struktur bildenden Schicht (3) oder Schichtfolge strukturiert wird, um eine geometrische Form von Bereichen der freitragenden Struktur festzulegen.

6. Verfahren nach Anspruch 5,
**dadurch gekennzeichnet,**
**dass** die Strukturierung der Opferschicht (4) derart erfolgt, dass an die Schutzschicht (15) angrenzende Bereiche der die freitragende Struktur bildenden Schicht (3) oder Schichtfolge auf einem Rand der Schutzschicht (15) aufliegen.

7. Verfahren nach einem der Ansprüche 1 bis 6,
**dadurch gekennzeichnet,**
**dass** die die freitragende Struktur bildende Schicht (3) oder Schichtfolge nach der Abscheidung strukturiert wird.

## Claims

1. A method for producing a micromechanical component comprising at least one self-supporting structure, in which a conductive track plane (11) and a sacrificial layer (4) are applied to a substrate (2) in such a way that the conductive track plane (11) lies between the substrate (2) and the sacrificial layer (4) or within the sacrificial layer (4), a layer (3) or layer sequence forming the self-supporting structure is deposited on the sacrificial layer (4), and the sacrificial layer (4) is removed, in part, by an etching process in order to finish the self-supporting structure,
an electrically conductive protective layer (15) being embedded, when the sacrificial layer (4) is applied on top of a region of the conductive track plane (11) to be protected, in the sacrificial layer (4) at a distance from the conductive track plane (11) and serves as an etching stop layer during the etching process for the removal of the sacrificial layer (4),
**characterised in that**
the protective layer (15) is removed by an etching process once the self-supporting structure is finished, which etching process acts selectively on a remaining part (17), beneath the protective layer (15), of the sacrificial layer which remains on the conductive track plane (11).

2. The method according to claim 1,
**characterised in that**
once the self-supporting structure has been finished a protective covering (14) is first applied over the self-supporting structure, which protective covering hermetically seals the self-supporting structure against external influences, and the protective layer (15) is then removed by the etching process.

3. The method according to either claim 1 or claim 2,
**characterised in that**
the conductive track plane (11) is first applied to the substrate (2) and structured, and the sacrificial layer (4) is then applied, the application of the sacrificial layer (4) being interrupted when a first layer thickness is reached, the protective layer (15) is deposited and is structured over the region to be protected for local retention, and the application of the sacrificial layer (4) is then continued.

4. The method according to either claim 1 or claim 2,
**characterised in that**
the application of the sacrificial layer (4) is interrupted when a first layer thickness is reached, the conductive track plane (11) is applied and structured, the application of the sacrificial layer (4) is continued and interrupted again when a second layer thickness is reached, the protective layer (15) is deposited and structured for local retention over the region to be protected, and the application of the sacrificial layer (4) is again continued.

5. The method according to any one of claims 1 to 4,
**characterised in that**
the sacrificial layer (4) is structured before the layer (3) or layer sequence forming the self-supporting structure is deposited so as to define a geometric shape of regions of the self-supporting structure.

6. The method according to claim 5,
**characterised in that**
the sacrificial layer (4) is structured in such a way that regions, adjacent to the protective layer (15), of the layer (3) or layer sequence forming the self-supporting structure rest against an edge of the protective layer (15).

7. The method according to any one of claims 1 to 6,
**characterised in that**
the layer (3) or layer sequence forming the self-supporting structure is structured after the deposition process.

## Revendications

1. Procédé de fabrication d'un élément de construction micromécanique avec au moins une structure suspendue, au cours duquel on applique un niveau de pistes conductives (11) et une couche sacrificielle (4) sur un substrat (2) de telle sorte que le niveau de pistes conductives (11) se situe entre le substrat (2) et la couche sacrificielle (4) ou à l'intérieur de la couche sacrificielle (4), on dépose sur la couche sacrificielle (4) une couche (3) ou une séquence de couches formant la structure suspendue et en ce que, pour achever la couche suspendue, on retire la couche sacrificielle (4) par un processus de morsure,
sachant que lors de l'application de la couche sacrificielle (4) on incorpore au-dessus d'une zone à protéger du niveau de pistes conductives (11) à une distance du niveau de pistes conductives (11) une couche de protection conductrice d'électricité (15) servant de couche d'arrêt de la morsure, lors du processus de morsure destiné à retirer la couche sacrificielle (4),
**caractérisé en qu'**
après achèvement de la structure suspendue, on retire la couche de protection (15) par un processus de morsure, qui agit sélectivement sur une partie (17) de la couche sacrificielle (4) restant sous la couche de protection (15), qui demeure sur le niveau de piste conductive (11).

2. Procédé selon la revendication 1,
**caractérisé en ce qu'**
après l'achèvement de la structure suspendue, on applique d'abord sur la structure suspendue un revêtement protecteur (14) qui ferme hermétiquement la structure suspendue pour la protéger contre des influences extérieures, puis on retire la couche de protection (15) par processus de morsure.

3. Procédé selon la revendication 1 ou 2,
**caractérisé en ce qu'**
on applique d'abord le niveau de pistes conductives (11) sur le substrat (2) et on le structure, puis on applique la couche sacrificielle (4), l'application de la couche sacrificielle (4) étant interrompue à l'atteinte d'une première épaisseur de couche, on dépose la couche de protection (15) et on la structure pour une persistance locale sur la couche à protéger, puis on poursuit l'application de la couche sacrificielle (4).

4. Procédé selon la revendication 1 ou 2,
**caractérisé en ce qu'**
on interrompt l'application de la couche sacrificielle (4) à l'atteinte d'une première épaisseur de couche, on applique et on structure le niveau de pistes conductives (11), on poursuit l'application de la couche sacrificielle (4) et on l'interrompt une nouvelle fois à l'atteinte d'une deuxième épaisseur de couche, on dépose la couche de protection (15) et on la structure pour la persistance par-dessus la zone à protéger, et par la suite, on poursuit une fois encore l'application de la couche sacrificielle (4).

5. Procédé selon l'une quelconque des revendications 1 à 4,
**caractérisé en ce qu'**
on structure la couche sacrificielle (4) avant le dépôt de la couche ou séquence de couches formant la structure suspendue (3) pour déterminer une forme géométrique de zones de la structure suspendue.

6. Procédé selon la revendication 5,
**caractérisé en ce qu'**
on procède à la structuration de la couche sacrificielle (4) de telle sorte que des zones adjacentes à la couche de protection (15) de la couche (3) ou séquence de couches formant la structure suspendue reposent sur un bord de la couche de protection (15).

7. Procédé selon l'une quelconque des revendications 1 à 6,
**caractérisé en ce qu'**
on structure la couche (3) ou séquence de couches formant la structure suspendue après le dépôt.
